# EUROPÄISCHE PATENTSCHRIFT

(11) **EP 2 040 298 B1**
(45) Veröffentlichungstag und Bekanntmachung des Hinweises auf die Patenterteilung: **12.09.2018**
(21) Anmeldenummer: 08171532.8
(22) Anmeldetag: 31.01.2005
(51) Int. Cl.: H01L 27/08, H01L 29/423

(54) **Integrierte Schaltungsanordnungen mit ESD-festem Kondensator und Herstellungsverfahren**
Integrated circuit arrangements with ESD-resistant capacitor and method of production
Circuits intégrés comprenant un condensateur qui résiste aux décharges électrostatiques et procédé de réalisation

(30) Priorität: 10.02.2004 DE 102004006484
(43) Veröffentlichungstag der Anmeldung: 25.03.2009
(62) Teilanmeldung aus: 05701625.5
(73) Patentinhaber: Infineon Technologies AG, 85579 Neubiberg (DE)
(72) Erfinder: Esmark, Kai, 82061, Neuried (DE); Gossner, Harald, 85521, Riemerling (DE); Russ, Christian, 86420, Diedorf (DE); Schneider, Jens, 81379, München (DE)
(74) Vertreter: Kindermann, Peter

(56) Entgegenhaltungen:
- US-A- 5 608 258
- US-A- 5 656 834
- US-A- 5 767 531
- US-A1- 2002 140 109

## Beschreibung

Die Erfindung betrifft u.a. eine integrierte Schaltungsanordnung mit einer Bezugs-Betriebspotenzialleitung, die im Betrieb der Schaltungsanordnung ein Grundpotenzial führt, z.B. ein Massepotenzial, und mit einer positiven Betriebspotenzialleitung, die im Betrieb der Schaltungsanordnung ein im Vergleich zu dem Grundpotenzial positiveres Potenzial führt, z.B. ein Pluspotenzial. Außerdem enthält die integrierte Schaltungsanordnung einen zwischen den Betriebspotenzialleitungen geschalteten Kondensator. Solche Kondensatoren werden insbesondere für Schaltungen mit einer analogen Signalverarbeitung eingesetzt. Diese Kondensatoren werden auch als Entkopplungskondensatoren, Blockkondensatoren oder Stützkondensatoren bezeichnet. Die Kondensatoren entkoppeln und stabilisieren die Versorgungsspannung der integrierten Schaltungsanordnung.

Der Kondensator lässt sich als sogenannter NCAP (N well CAPacitor) bzw. PCAP (P well CAPacitor) ausführen und enthält dann die folgenden Bereiche:
- einen Grunddotierbereich, der gemäß einem Grunddotiertyp dotiert ist,
- mindestens einen vorzugsweise an den Grunddotierbereich angrenzenden dotierten Anschlussbereich, der gemäß dem Grunddotiertyp dotiert ist und dessen maximale Dotierstoffkonzentration höher als die maximale Dotierstoffkonzentration im Grunddotierbereich ist,
- einen mit Abstand zum Grunddotierbereich angeordneten Elektrodenbereich, der in Anlehnung an den Aufbau eines MOS-Transistors (Metal Oxide Semiconductor) auch als Gatebereich bezeichnet wird, und
- ein zwischen dem Elektrodenbereich und dem Grunddotierbereich angeordnetes Dielektrikum.

Um den Kondensator gegen EOS Phänomene (Electrical Overstress) und insbesondere gegen ESD-Phänomene (ElectroStatic Discharge) zu schützen enthält die integrierte Schaltungsanordnung mindestens ein dem Kondensator parallel geschaltetes Schutzelement, das beim Überschreiten einer bestimmten Spannung, die oberhalb der Betriebsspannung oder unterhalb des Massepotentials bei einer Rückwärts-ESD-Polarität liegt, gut leitfähig wird, z.B. eine Schutzdiode, einen MOS-Transistor, einen Bipolartransistor, einen Thyristor, eine Zenerdiode, einen Diodenstack usw. oder Kombinationen hiervon. ESD-Fälle treten besonders dann auf, wenn die Schaltungsanordnung noch nicht im betriebsbereiten Zustand ist, d.h. während der Fertigung der Schaltungsanordnung, während des Einbaus in ein Chipgehäuse oder während der Montage auf eine Leiterplatte. Bspw. hat ein ESD-Spannungsimpuls eine Spannung größer 100 Volt und eine Dauer von etwa 100 Nanosekunden.

Aus der US 2002/0140109 A1 sind eine Vielzahl von Entkopplungskondensatoren für dünne Gateoxide bekannt.

Ferner offenbart die Druckschrift US 5 767 531 A einen Dünnschichttransistor (TFT) für Flüssigkristall-Anzeigen, bei dem zur Verbesserung einer Anzeigequalität und eines verringerten Abschaltstroms ein über dem Kanalbereich befindliches Dielektrikum unterschiedliche Schichtdicken aufweist.

Es ist Aufgabe der Erfindung eine integrierte Schaltungsanordnung mit mindestens einem Kondensator anzugeben, wobei die Schaltung trotz guter elektrischer Eigenschaften auch nach Belastung mit elektrostatischen Entladungen funktionsfähig bleibt, bei denen bisher eingesetzte Kondensatoren beschädigt werden. Insbesondere soll eine im ESD-Fall robuste Schaltungsanordnung bzw. deren Geometrie angegeben werden. Außerdem sollen Herstellungsverfahren für integrierte Schaltungsanordnungen angegeben werden.

Erfindungsgemäß wird diese Aufgabe hinsichtlich der integrierten Schaltungsanordnung durch die Merkmale des Patentanspruchs 1 und hinsichtlich des Verfahrens durch die Maßnahmen des Patentanspruchs 7 gelöst. Weiterbildungen sind in den Unteransprüchen angegeben.

Die Erfindung geht von der Überlegung aus, dass NCAP- bzw. PCAP-Kondensatoren eine große flächenbezogene Kapazität haben, so dass auch bei kleiner Chipfläche vergleichsweise große Kapazitätswerte erreichbar sind, bspw. im Vergleich zu p-n-Sperrschichtkapazitäten. Außerdem sind die RC-Zeitkonstanten des Kondensators von Bedeutung. Bei vielen Anwendungen muss insbesondere der parasitäre Serienwiderstand des Kondensators klein sein.

Die Erfindung geht weiterhin von der Überlegung aus, dass bei einem NCAP bzw. einem PCAP das Dielektrikum möglichst dünn sein muss, um eine hohe flächenbezogene Kapazität zu erzielen. Bspw. beträgt die Dicke des Dielektrikums weniger als zwei Nanometer, insbesondere bei Technologien mit minimalen lithografischen Abmessungen kleiner als 100 Nanometer und Betriebsspannungen kleiner als zwei Volt. Außerdem bauen sich trotz der Beschaltung mit der ESD-Schutzschaltung im ESD-Fall Spannungen von einigen Volt, z.B. von 5 oder 6 Volt, über dem Dielektrikum auf. Ein so dünnes Dielektrikum jedoch kann dann bereits durch kurzzeitig auftretende Spannungen von vier Volt geschädigt werden, was zum Ausfall der gesamten integrierten Schaltungsanordnung führen kann.

Deshalb gilt für die erfindungsgemäße Schaltungsanordnung, dass:
- entweder bei einem Grunddotierbereich vom n-Grunddotiertyp der Anschlussbereich elektrisch leitfähig mit der positiven Betriebspotenzialleitung und der Elektrodenbereich mit der Bezugs-Betriebspotenzialleitung elektrisch leitfähig verbunden ist oder dass bei einem p-Grunddotiertyp der Anschlussbereich elektrisch leitfähig mit der Bezugs-Betriebspotenzialleitung und der Elektrodenbereich mit der positiven Betriebspotenzialleitung elektrisch leitfähig verbunden ist.

Bei einer Weiterbildung ist zwischen dem Grunddotierbereich und dem Dielektrikum ein gemäß einer Hilfsdotierung mit dem Grunddotiertyp dotierter Hilfsdotierbereich angeordnet, dessen maximale Dotierstoffkonzentration gleich der maximalen Dotierstoffkonzentration im Grunddotierbereich oder größer als diese Dotierstoffkonzentration ist.

Durch diese Maßnahmen wird einerseits erreicht, dass im ESD-Fall, insbesondere bei einer ESD-Spannung mit einer Polarität, für welche die hinzugeschaltete Schutzschaltung weniger schützt, in dem Grunddotierbereich und auch in der optionalen Hilfsdotierschicht eine sogenannte Verarmung von Ladungsträgern eintritt, d.h. eine sogenannte Verarmungsschicht bzw. depletion Layer gebildet wird, die eine dielektrische Wirkung hat und damit zu einer größeren wirksamen Dielektrikumsdicke führt. Gegebenenfalls ist die ESD-Spannung am Kondensator so hoch, dass nicht nur eine Verarmung in der Hilfsdotierschicht auftritt, sondern dass auch Bedingungen für die Bildung eines Inversionskanals gegeben sind. Jedoch gelangen auf Grund des Dotiertyps des Anschlussbereiches in den Inversionskanal keine Ladungsträger, die die wirksame dielektrische Dicke wieder herabsetzen würden.

Andererseits wird aber in der Normalbetriebsart der Schaltungsanordnung durch den Hilfsdotierbereich und die angegebene Polung erreicht, dass sich die Kapazität durch die für den ESD-Fall erläuterten Zusammenhänge nicht zu stark verringert. Insbesondere ist bspw. die Dicke der Verarmungsschicht auf Grund der Hilfsdotierschicht kleiner als ohne eine solche Hilfsdotierschicht.

Da der Kondensator zwischen den Betriebspotenzialleitungen geschaltet ist, fällt über ihm im ESD-Fall eine große Spannung ab, weil ein Spannungsteilereffekt wie bei einer Reihenschaltung von Transistoren oder Kondensatoren nicht auftritt. Eine solche Reihenschaltung tritt insbesondere in funktionalen Blöcken auf wo z.B. PMOS und NMOS in Serienschaltung als Inverter verwendet werden. Insbesondere ist der Kondensator in der Kernlogik der Schaltungsanordnung, oder in einem sogenannten analogem Makroblock enthalten.

Die erfindungsgemäße Schaltungsanordnung ist im ESD-Fall robust, weil die elektrische Feldstärke im Dielektrikum oder in den am meisten gefährdeten Überlappungsregionen von Dielektrikum und Anschlussbereichen bzw. Erweiterungsbereichen reduziert wird.

Mit dem Hilfsdotierbereich lässt sich also die ESD-Festigkeit besser einstellen, ohne dass die Dicke des Dielektrikums, bspw. eines Oxides, verändert werden muss. Oft gibt es nur zwei wählbare Dielektrikumsdicken in einem Herstellungsprozess, so dass durch die Hilfsdotierung ein frei wählbarer und feiner einstellbarer Optimierungsparameter zur Verfügung steht und eine Überdimensionierung vermieden wird. Die Hilfsdotierung wird bei einem Ausführungsbeispiel nicht ganz frei gewählt, sondern stimmt mit einer im Prozess ohnehin zur Verfügung stehenden Implantationen überein, von denen aber verschiedene ausgewählt werden können.

Der Hilfsdotierbereich liegt bei einer Ausgestaltung an der Oberfläche eines Substrates und kann damit leicht eingebracht werden. Das Substrat ist bei einer anderen Ausgestaltung ein monokristallines Substrat, insbesondere ein Siliziumsubstrat. Solche Substrat sind hochrein. Auf Grund der Reinheit und des einkristallinen Materials können die Substrate ein vergleichsweise große Feldstärke tragen, was auch im ESD-Fall von großer Bedeutung ist, um einen Durchbruch zu verhindern. Außerdem lässt sich die Dotierstoffkonzentration im Hilfsdotierbereich sowie das Dotierprofil auf Grund der Oberflächenlage, der Reinheit bzw. des einkristallinen Materials reproduzierbar einstellen, insbesondere in einem einfachen Herstellungsprozess. Die Dotierstoffkonzentration und das Dotierstoffprofil des Grunddotierbereiches bzw. Hilfsdotierbereiches sind für die Dicke der Verarmungsschicht bestimmend.

Zur Dotierung des Hilfsdotierbereiches wird eine Implantation genutzt oder es werden mehrere Implantationen genutzt, bspw. Implantationen, die in dem Herstellungsprozess der Schaltungsanordnung zum Einstellen verschiedener Schwellspannungen von Feldeffekttransistoren bisher jeweils in voneinander verschiedenen Bereichen der Schaltungsanordnung eingesetzt worden sind. Die Dotierung des Hilfsdotierbereiches wird vorzugsweise einer Wannendotierung bzw. Grunddotierung überlagert. Die Nutzung von mehreren oder einer ausgewählten Implantation zum Einstellen der Schwellspannung eines Transistors auch zum Herstellen des Hilfsdotierbereiches ermöglicht eine Optimierung ohne Zusatzschritte, insbesondere eine Optimierung der Dicke der sich bildenden Verarmungsschicht in der Normalbetriebsart der Schaltungsanordnung und damit auch des Spannungsabfalls über der Verarmungsschicht. Je kleiner die Dotierstoffkonzentration in dem Hilfsdotierbereich , desto dicker ist die Verarmungsschicht und desto größer wird die ESD-Robustheit. Dagegen führt eine höhere Dotierstoffkonzentration in dem Hilfsdotierbereich zu einer dünneren Verarmungsschicht, die jedoch im Normalbetrieb die flächenbezogene Kapazität kaum beeinträchtigt. Aber auch die dünne Verarmungsschicht ermöglicht noch einen ausreichende ESD-Robustheit.

Auf Grund der Polung des Kondensators gibt es bei der Verwendung einer N-Wanne (im Falle eines P-vordotierten Substrates) oder einer P-Wanne (für N-Substrat) für den Grunddotierbereich zusätzlich zu der Kapazität des Kondensators noch eine zusätzliche p-n-Sperrschichtkapazität zum Substrat. Die Sperrschichtkapazität ist der Kapazität des Kondensators parallel geschaltet, so dass sich die flächenbezogene Kapazität erhöht.

Durch geeignete Silizidblockierung bei der Silizidbildung auf dem Anschlussbereich und auf dem Elektrodenbereich bzw. dem Gatebereich lässt sich die Durchbruchsfestigkeit des Kondensators weiter erhöhen.

Die erläuterten technischen Wirkungen der erfindungsgemäßen Schaltungsanordnung sind unabhängig vom Material, das für den Elektrodenbereich verwendet wird, und von einer Dotierung des Elektrodenbereiches. Damit können diese Wirkungen sowohl bei polykristallinen Elektrodenbereichen als auch bei Elektrodenbereichen aus Metall erzielt werden, insbesondere in zukünftigen Technologien.

Die auf die integrierte Schaltungsanordnung bezogene Aufgabe wird gemäß einem zweiten Aspekt außerdem durch eine integrierte Schaltungsanordnung gemäß Patentanspruch 7 gelöst. Weiterbildungen sind in den Unteransprüchen angegeben.

Die Erfindung geht sowohl beim ersten Aspekt aber insbesondere auch bei dem zweiten Aspekt von der experimentell gewonnenen Erkenntnis aus, dass der gefährdetste Teil des Dielektrikums während einer ESD-Entladung die Region ist, in der der Elektrodenbereich bzw. der Gatebereich den dotierten Anschlussbereich bzw. einen Erweiterungsbereich überlappt.

In einem typischen Prozess stehen nur zwei oder höchsten drei verschiedene Gateoxiddicken zur Verfügung. Bei der erfindungsgemäßen Schaltungsanordnung wird dies ausgenutzt, um in einem Kondensator ein duales Dielektrikum auszubilden, das einen dünnen zentralen Bereich und einen dazu im Vergleich dickeren Randbereich enthält. Durch die Wahl der Breite des dickeren Randbereiches des Dielektrikums lässt sich eine Optimierung derart durchführen, dass einerseits die Kapazität im Vergleich zu der Verwendung eines ausschließlich dünnen Dielektrikums nicht übermäßig erniedrigt wird und dass andererseits die ESD-Festigkeit ausreichend ist, ohne dass eine Überdimensionierung auftritt, wie es bei einem ausschließlich dickem Dielektrikum der Fall wäre.

Weiterhin betrifft die Erfindung Herstellungsverfahren für integrierte Schaltungsanordnungen. Für die Herstellungsverfahren und deren Weiterbildungen gelten die oben genannten technischen Wirkungen ebenfalls.

Zur Ausbildung des dualen Dielektrikums gibt es verschiedene Möglichkeiten:
- das dünne Dielektrikum wird gleichzeitig mit einer dem Grunddotierbereich nahen Schicht des dicken Dielektrikums ausgebildet. Anschließend wird eine weitere Schicht des dicken Dielektrikums erzeugt, wobei das dünne Dielektrikum maskiert wird, bspw. durch eine Resistschicht.
- das dünne Dielektrikum wird komplett vor dem Ausbilden des dicken Dielektrikum ausgebildet. Anschließend wird das dünne Dielektrikum maskiert und das dicke Dielektrikum wird erzeugt.
- das dünne Dielektrikum wird nach dem Ausbilden einer dem Grunddotierbereich nahen Schicht des dicken Dielektrikums ausgebildet, wobei vorzugsweise gleichzeitig eine weitere Schicht des dicken Dielektrikums erzeugt wird.

Zur Bildung der Dielektrika sind insbesondere thermische Oxidationen geeignet. Bereiche an denen das Silizium zugänglich sein soll, werden bspw. später freigeätzt.

Im Folgenden wird die Erfindung an Hand der beiliegenden Zeichnungen erläutert. Darin zeigen:
- Figur 1: eine integrierte Schaltungsanordnung 10 mit einem n-Wannenkondensator 12,
- Figur 2: Masken, die bei der Herstellung eines weiteren n-Wannenkondensators eingesetzt werden, und
- Figur 3: einen n-Wannenkondensator mit dualem Gateoxid.

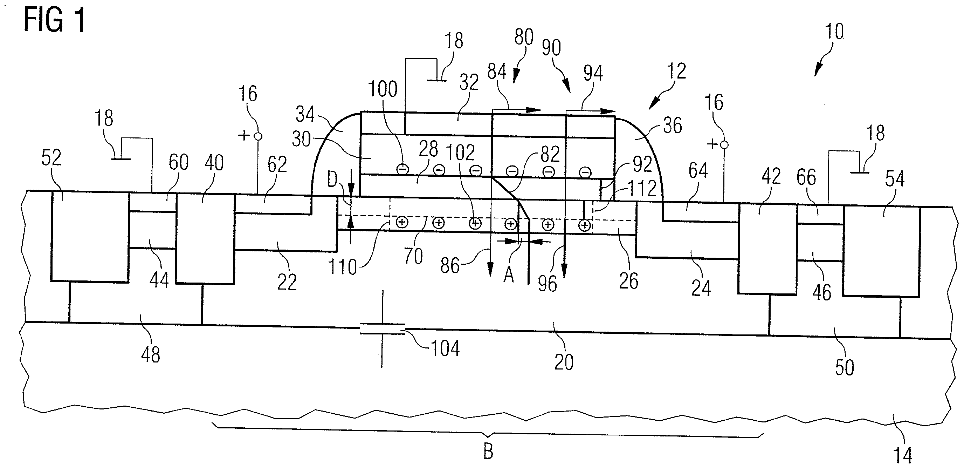

Figur 1 zeigt eine integrierte Schaltungsanordnung 10, die einen ESD-festen n-Wannen-Kondensator 12 enthält. Die integrierte Schaltungsanordnung 10 enthält auf einem im Ausführungsbeispiel leicht p-dotiertem einkristallinem Siliziumsubstrat 14 außerdem:
- eine Plusleitung 16, die zu einem Plusanschlusspad führt,
- eine Masseleitung 18, die zu einem Masseanschlusspad führt,
- eine nicht dargestellte ESD-Schutzschaltung, und
- eine Vielzahl von nicht dargestellten Transistoren, z. B. Speichertransistoren oder Transistoren einer Logikschaltung oder einer Analogschaltung, insbesondere Feldeffekttransistoren.

Der Wannen-Kondensator 12 enthält:
- eine n-dotierte Wanne 20, die bspw. eine maximale Dotierstoffkonzentration von 1 10¹⁷ bis 1 10¹⁸ Dotierstoffatome je Kubikzentimeter hat, z.B. Phosphoratome oder Arsenatome. Die Wanne 20 hat bspw. eine Tiefe von 1500 Nanometern, eine Breite B und eine Länge von jeweils typisch bis zu 100 Mikrometern.
- stark n-dotierte Anschlussbereiche 22 und 24 bzw. Source/Drain-Bereiche die typischerweise jeweils entlang der Längsseiten der Wanne 20, wobei die maximale Dotierstoffkonzentration bspw. im Bereich von 1 10²⁰ bis 10 10²¹ Dotierstoffatome je Kubikzentimeter liegt. Die Anschlussbereiche 22, 24 haben im Ausführungsbeispiel eine Tiefe von typisch 200nm.

Mit zunehmendem Abstand vom Substrat 14 enthält der Kondensator 12 in der im Folgenden angegebenen Reihenfolge außerdem:
- einen n-dotierten optionalen Hilfsdotierbereich 26 zwischen den Anschlussbereichen 22 und 24. Im Ausführungsbeispiel grenzt der Hilfsdotierbereich 26 auf der einen Seite an den Anschlussbereich 22 und auf der anderen Seite an den Anschlussbereich 24 an und erstreckt sich zwischen den beiden Anschlussbereichen 22 und 24 ohne Unterbrechung. Alternativ grenzt der Hilfsdotierbereich an n-dotierte Erweiterungsbereiche an, die an den Anschlussbereichen 22, 24 ausgebildet sind. Die Erweiterungsbereiche werden auch als LDD-Bereiche (Lightly Doped Drain) bezeichnet weil ihre Dotierstoffkonzentration geringer als die der Anschlussbereiche 22, 24 ist, jedoch höher als die des Hilfsdotierbereiches. Der Hilfsdotierbereich 26 hat bspw. in einer Tiefe von 100 Nanometer und eine maximale Dotierstoffkonzentration im Bereich von 1 10¹⁷ bis 1 10¹⁸ Dotierstoffatome je Kubikzentimeter.
- ein Dielektrikum 28, das sich an der Oberfläche des Hilfsdotierbereiches 26 entlang erstreckt und das mit Abstand zu den Anschlussbereichen 22, 24 angeordnet ist. Das Dielektrikum 28 wird auch als Gateoxid (GOX) bezeichnet und besteht bspw. aus Siliziumdioxid (εr=3,9) oder einem Material mit einer relativen Dielektrizitätskonstante größer als 3,9, insbesondere aus einem sogenannten high-k Dielektrikum Im Ausführungsbeispiel hat das Dielektrikum 28 eine Dicke von zwei Nanometern.

- einen Gatebereich 30, der (nach oben) an das Dielektrikum 28 angrenzt, und der aus dotiertem polykristallinem Silizium besteht, bspw. aus n- oder p-dotiertem Polysilizium mit einer maximalen Dotierstoffkonzentration größer als 5 10¹⁹ Dotierstoffatome je Kubikzentimeter. Der Gatebereich 30 hat eine Dicke im Bereich von bspw. 100 Nanometer bis 400 Nanometer.
- ein Silizidbereich 32 der sich auf dem Gatebereich 28 erstreckt und bspw. eine Dicke von 40-60 Nanometern hat.

Im Ausführungsbeispiel erstrecken sich die Anschlussbereiche 22, 24 nicht unterhalb des Dielektrikums 28.

Der aus dem Dielektrikum 28, dem Gatebereich 30 und dem Silizidbereich 32 gebildete Stapel wird seitlich durch zwei elektrisch isolierende Abstandselemente 34, 36 begrenzt, die jeweils eine Fußbreite von bspw. 40 Nanometern haben und die die Anschlussbereiche 22 und 24 teilweise überlappen. Die Abstandselemente 34, 36 werden auch als Spacer bezeichnet.

Zwei Isoliergräben 40 und 42 sind seitlich der Wanne 20 angeordnet. Der Isoliergraben 40 trennt den Anschlussbereich 22 von einem Substratanschlussbereich 44 ab. Der Isoliergraben 42 trennt dagegen den Anschlussbereich 24 von einem Substratanschlussbereich 46 ab. Die Substratanschlussbereiche 44, 42 sind stark p-dotiert. Unterhalb des Substratanschlussbereiches 44 bzw. 46 liegt ein p-dotierter Zwischenbereich 48 bzw. 50, der sich bis zum Substrat 14 erstreckt. Die Substratanschlussbereiche 48 und 50 werden möglichst nah am Kondensator 12 angeordnet, d.h. unmittelbar an der n-Wanne 20.

Zwei weitere Isoliergräben 52 und 54 begrenzen den Substratanschlussbereich 44 bzw. 46. Die Isoliergräben 40, 42, 52 und 54 haben eine Tiefe von bspw. 250 bis 500 Nanometern und werden auch als STI-Gräben (Shallow Trench Isolation) bezeichnet. Die Isoliergräben 40, 42, 52 und 54 sind mit einem elektrisch isolierenden Material gefüllt.

Ein Silizidbereich 60 erstreckt sich zwischen dem Isoliergraben 52 und dem Isoliergraben 40 an der Oberfläche des Substratanschlussbereiches 48. Der Silizidbereich 60 ist mit der Masseleitung 18 elektrisch leitfähig verbunden.

Ein weiterer Silizidbereich 62 erstreckt sich zwischen dem Isoliergraben 40 und dem Abstandselement 34 an der Oberfläche des Anschlussbereiches 22. Der Silizidbereich 62 ist mit der Plusleitung 16 elektrisch leitfähig verbunden.

Ein nächster Silizidbereich 64 erstreckt sich zwischen dem Abstandselement 36 und dem Isoliergraben 42 an der Oberfläche des Anschlussbereiches 24. Der Silizidbereich 64 ist ebenfalls mit der Plusleitung 16 elektrisch leitfähig verbunden.

Ein Silizidbereich 66 erstreckt sich zwischen dem Isoliergraben 42 und dem Isoliergraben 54 an der Oberfläche des Substratanschlussbereiches 46. Der Silizidbereich 66 ist mit der Masseleitung 16 elektrisch leitfähig verbunden.

Zur Erläuterung des verbesserten ESD-Schutzes sei eine ESD-Fall angenommen, bei dem ein Spannungsimpuls eine Polarität hat, die mit der Polarität der Spannung übereinstimmt, die in der Normalbetriebsart der Schaltungsanordnung 10 am Kondensator 12 anliegt. Im ESD-Fall - wie auch in der Normalbetriebsart - bildet sich eine Verarmungsschicht 70, die bspw. eine Schichtdicke D von einigen Nanometern hat, bspw. eine Schichtdicke von zwei Nanometern. Die Verarmungsschicht 70 hat auf Grund der fehlenden Ladungsträger eine dielektrische Wirkung mit einer relativen Dielektrizitätskonstante von zwölf (sr von Silizium) und führt zu einer kleineren elektrischen Feldstärke im Dielektrikum 28, da sie als kapazitiver Spannungsteiler wirkt, der in Reihe zum Gateoxid-Kondensator geschaltet ist.

In einem Koordinatensystem 80 ist der Potenzialverlauf 82 entgegen der Normalenrichtung der Oberfläche des Substrates 14 im Kondensator 12 dargestellt. Eine y-Achse 84 des Koordinatensystems 80 zeigt das Potenzial im Bereich von 0 Volt bis bspw. 5 Volt. Eine x-Achse 86 des Koordinatensystems 80 zeigt die Ortskoordinate im Kondensator 12 mit zunehmendem Abstand von dem Silizidbereich 32. Im Silizidbereich 32 und im Gatebereich 30 liegt Massepotenzial an, d.h. null Volt. Im Dielektrikum 28 steigt das Potenzial linear an. Das Potenzial erhöht sich in der Verarmungsschicht 70 weiter linear, bspw. bis auf vier Volt, jedoch mit einem flacheren Anstieg als im Dielektrikum 28. Auf Grund der Verarmungsschicht 70 ergibt sich also ein Potenzialanstieg A außerhalb des Dielektrikums 28 bzw. mit anderen Worten eine Spannungsverringerung über dem Dielektrikum 28.

In einem Koordinatensystem 90 ist der Feldstärkeverlauf 92 entgegen der Normalenrichtung der Oberfläche des Substrates 14 im Kondensator 12 dargestellt. Eine y-Achse 94 des Koordinatensystems 90 zeigt die Feldstärke E im Bereich von 0 Volt/Nanometer bis bspw. 2,5 Volt/Nanometer. Eine x-Achse 96 des Koordinatensystems 90 zeigt die Ortskoordinate im Kondensator 12 mit zunehmendem Abstand von dem Silizidbereich 32. Im Silizidbereich 32 und im Gatebereich 30 beträgt die Feldstärke E null Volt/Nanometer. Im Dielektrikum hat die Feldstärke E einen Wert von bspw. zwei Volt/Nanometer. In der Verarmungsschicht ist der Wert der Feldstärke kleiner als im Dielektrikum 28, bspw. ein Volt/Nanometer. In der n-Wanne 20 beträgt die Feldstärke E wieder null Volt/Nanometer.

Negative Ladungen 100 und positive Ladungen 102 verdeutlichen die Wirkung des Dielektrikums 28 und der Verarmungsschicht 70 als Kondensatordielektrikum. Außerdem ist in Figur 1 ein p-n-Sperrschichtkondensator 104 dargestellt, der durch die Sperrschicht zwischen der n-Wanne und dem Substrat 14 gebildet wird und der parallel zum Kondensator 12 geschaltet ist, so dass verschiedene Kondensatorarten parallel geschaltet sind.

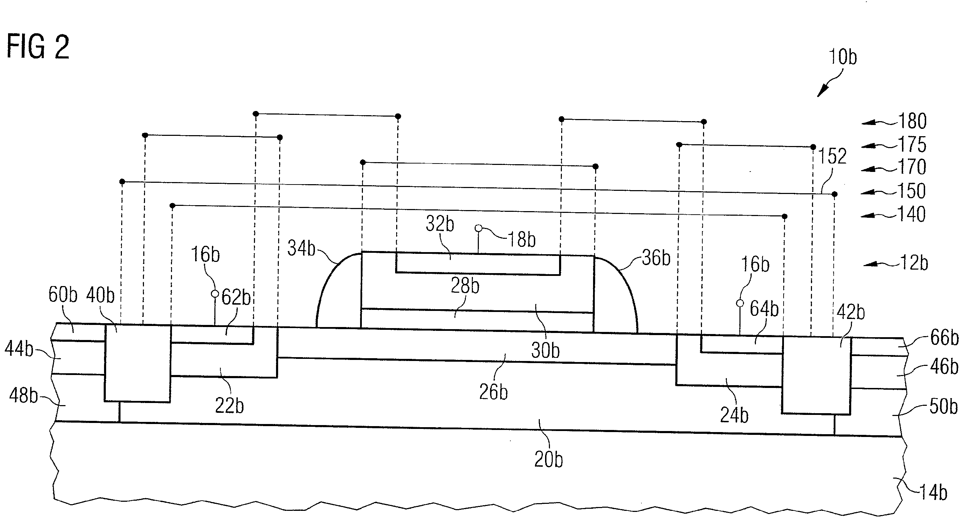

Bei einem anderen Ausführungsbeispiel wird an Stelle des Polysiliziums für den Gatebereich 30 eine Metallelektrode verwendet, bspw. aus Aluminium. Bei einem nächsten Ausführungsbeispiel sind die Anschlussbereiche 22, 24 weiter von den Abstandselementen 34 und 36 entfernt, siehe Figur 2, Anschlussbereiche 22b, 24b.

Bei einem nächsten Ausführungsbeispiel erstreckt sich der Hilfsdotierbereich 26 nur in einem mittleren Bereich unter dem Dielektrikum 28, siehe Seitenkanten 110 und 112. Der Abstand der Seitenkante 110 bzw. 112 des Hilfsdotierbereiches 26 zu dem nächstgelegenen Anschlussbereich 22 bzw. 24 im Fall von fehlenden Erweiterungsbereichen bzw. bis zum nächstgelegenen Erweiterungsbereich beträgt bspw. mindestens 100 Nanometer. In diesem Fall bildet sich die Verarmungsschicht 70 unter den Randbereichen des Dielektrikums 28 dicker aus, was die Robustheit gegen ESD erhöht.

Figur 2 zeigt fotolithografische Masken, die bei der Herstellung eines n-Wannen-Kondensators 12b einer Schaltungsanordnung 10b in einem Prozess mit minimalen fotolithografischen Abmessungen kleiner als ein Mikrometer eingesetzt werden. Bis auf die unten erläuterten Abweichungen werden bei der Herstellung des Kondensators 12 die gleichen Schritte wie bei der Herstellung des Kondensators 12b durchgeführt. Die Schaltungsanordnung 10b ist wie die Schaltungsanordnung 10 aufgebaut. Der n-Wannenkondensator 12b stimmt bis auf die im Folgenden erläuterten Unterschiede mit dem Kondensator 12 überein, so dass gleiche Teile mit gleichen Bezugszeichen bezeichnet sind, denen jedoch zur Unterscheidung der beiden Kondensatoren 12 und 12b der Kleinbuchstabe b nachgestellt ist.

Der Kondensator 12b enthält insbesondere die folgenden Bestandteile, für die die oben getroffenen Aussagen bzgl. der entsprechenden Teile des Kondensators 12 gelten:
- ein Substrat 14b,
- eine Plusleitung 16b,
- eine Masseleitung 18b,
- eine Wanne 20b,
- Anschlussbereiche 22b, 24b,
- einen Hilfsdotierbereich 26b,
- ein Dielektrikum 28b,
- einen Gatebereich 30b,
- einen Silizidbereich 32b,
- Abstandselemente 34b, 36b,
- Isoliergräben 40b, 42b,
- Substratanschlussbereiche 44b, 46b,
- Zwischenbereiche 48b, 50b, und
- Silizidbereiche 60b bis 66b.

Der Kondensator 12b hat im Vergleich zum Kondensator 12 die folgenden Abweichungen:
- die Anschlussbereiche 22b und 24b sind mit Abstand zu den Abstandselementen 34b bzw. 36b angeordnet, so dass keine Berührung und keine Überlappung in Normalenrichtung der Oberfläche des Substrats 14 gesehen auftritt,
- die Silizidbereiche 62b und 64b reichen nicht bis an die Abstandselemente 34b bzw. 36b heran und decken auch nur einen Teilbereich der Anschlussbereiche 22b und 24b ab, und
- der Silizidbereich 32b deckt ebenfalls nur einen Teilbereich des Gatebereiches 30b ab.

Durch die zurückgesetzten Anschlussbereiche 22b und 24b bzw. LDD-Bereiche sowie durch die zurückgesetzten Silizidbereiche 62b, 64b und 32b wird im ESD-Fall die im Dielektrikum 28b auftretende Feldstärke an den Kanten des Gatebereiches 30b verringert, wodurch die Durchbruchsspannung des Kondensators 12b ansteigt. Diese Aussage gilt unter der Annahme, dass unter ESD Bedingung ein gewisser Strom (Tunnelstrom) über das Gateoxid bzw. das Dielektrikum 28 fließt und damit zusätzliche Spannungsabfälle zu den in Figur 1 gezeigten Potentialverhältnissen auftreten. Im übrigen beruht die erhöhte ESD-Festigkeit und die hohe Flächenkapazität des Kondensators 12b auf den Zusammenhängen, die oben an Hand der Figur 1 für den Kondensator 12 erläutert worden sind.

Bei der Herstellung des Kondensators 12 bzw. 12b wird zunächst mit Hilfe einer Maske 140 unter Verwendung eines Resists die Lage der aktiven Gebiete und damit auch die Lage der Isoliergräben 40b und 42b festgelegt. Die Isoliergräben 40b und 42b werden geätzt, gefüllt und planarisiert. Danach wird die n-Wanne 20b implantiert, wobei eine nicht dargestellte Resistschicht mit einer Maske 150 belichtet wird, deren Maskenstruktur 152 die Lage der Wanne 20 vorgibt.

Anschließend wird mit einer nicht dargestellten Maske die Lage des Hilfsdotierbereiches 26b mit einem Resist vorgegeben. Der Resist wird entwickelt. Nach dem Entwickeln wird der Hilfsdotierbereich 26b mit Hilfe einer Implantation dotiert. Die Maske für den Hilfsdotierbereich 26b enthält im Bereich der n-Wanne 20b eine Maskenstruktur, die bspw. an der gleichen Stelle liegt wie die Maskenstruktur 152 in der Maske 150. In anderen Bereichen haben die beiden Masken jedoch voneinander abweichende Maskenstrukturen. Bei dem an Hand der Figur 1 erläuterten Ausführungsbeispiel mit verkürztem Hilfsdotierbereich legt die Maske für den Hilfsdotierbereich 26 die Lage der Kanten 110 und 112 fest. Die Implantation für den Hilfsdotierbereich 26 bzw. 26b erfolgt gleichzeitig mit Implantationen zum Einstellen der Schwellspannung in Feldeffekttransistoren der Schaltungsanordnung 10 bzw. 10b.

Anschließend wird das Dielektrikum 28b thermisch auf die Siliziumoberfläche aufgewachsen. Danach wird die polykristalline Schicht für den Gatebereich 30b abgeschieden und in-situ oder nachträglich dotiert, bspw. beim Durchführen einer oder mehrerer der im Folgenden genannten Implantationen:
- der Implantation für Erweiterungsbereiche,
- der Implantation für die Anschlussbereiche 22b, 24b, oder
- einer anderen Implantation.

Danach wird die Lage des Gatebereiches 30b mit Hilfe einer Maske 170 festgelegt. Die polykristalline Schicht wird dann in einem Ätzprozess strukturiert, vorzugsweise gleichzeitig mit dem Dielektrikum 28b.

Die Implantation für Erweiterungsbereiche wird zu diesem Zeitpunkt für die Schaltungsanordnung 10 jedoch nicht für die Schaltungsanordnung 10b durchgeführt. Vor der Durchführung dieser Implantationen werden bei der Herstellung der Schaltungsanordnung 12b die Abstandselemente 34b und 36b selbstausrichtend durch Schichtabscheidung und anisotropes Ätzen erzeugt.

Nach der Herstellung der Abstandselemente 34b und 36b wird eine Maske 175 verwendet, um die Lage der Anschlussbereich 22b und 24b festzulegen. Nach der Entwicklung eines Resists wird die Implantation für die Anschlussbereiche 22b und 24b sowie Erweiterungsbereiche (hier deckungsgleich mit 22b und 24b) durchgeführt.

Nach der Herstellung der Anschlussbereiche 22b und 24b folgt die Herstellung der Silizidbereiche 18b und 60b bis 66b. Zum Blockieren der Silizidbildung in bestimmten Bereichen werden mit Hilfe einer Maske 180 Blockierbereiche festgelegt, in denen bspw. eine zuvor aufgebrachte Nitridschicht stehen bleiben soll . Danach wird eine dünne Metallschicht von bspw. mehreren 10 Nanometern auf die Waferoberfläche aufgesputtert. Geeignete Metalle sind bspw. Titan, Kobalt oder Nickel. Bei einem Temperschritt wird das Silizid in Bereichen gebildet, an denen das Metall Silizium berührt. Das Silizid verringert den Anschlusswiderstand, so dass Signale hoher Frequenzen verarbeitet werden können. Anschließend werden das nicht in Silizid umgewandelte Metall und die Reste der Nitridschicht entfernt.

Die rückgesetzten Silizidbereiche verringern ebenfalls die Feldstärke im Dielektrikum in der Nähe der Kanten des Gatebereiches 30b. Experimentell konnten 0,5 Volt höhere transiente Durchbruchsspannungen durch das Silizidblockieren erreicht werden. Damit bilden sich Serienwiderstände aus, die im ESD-Fall Tunnelströmen entgegenwirken, die das Dielektrikum 28b schädigen.

Bei Herstellung des Kondensators 12 werden die Masken 175 und 180 nicht verwendet, da keine zurückgesetzten Anschlussbereiche erzeugt werden müssen und auch keine Silizidbildungsblockierung erforderlich ist. Die Implantation der Anschlussbereiche 22 und 24 sowie die Bildung der Silizidbereiche 32 und 60 bis 66 wird selbstausrichtend zu den Abstandselementen 34 und 36 durchgeführt.

Bei einem weiteren Ausführungsbeispiel wird die Silizidbildung nur an einem Teil des Gatebereiches oder nur an einem Teil der Anschlussbereiche blockiert. Bei einem weiteren Ausführungsbeispiel wird an Stelle des polykristallinen Gatebereiches 30b eine Gatebereich aus Metall verwendet, wobei sich eine Silizidbildung auf diesem Bereich erübrigt.

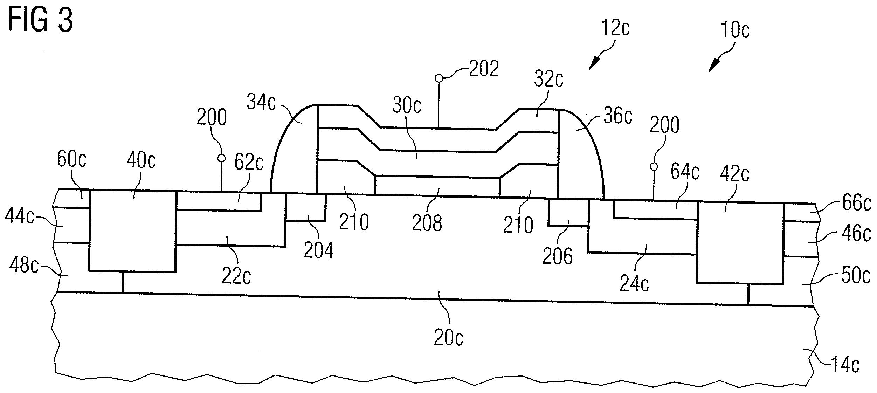

Figur 3 zeigt eine Schaltungsanordnung 10c, die einen n-Wannenkondensator 12c mit dualem Gateoxid enthält. Die Schaltungsanordnung 10c ist wie die Schaltungsanordnung 10 aufgebaut. Der n-Wannenkondensator 12c stimmt bis auf die im Folgenden erläuterten Unterschiede mit dem Kondensator 12 überein, so dass gleiche Teile mit gleichen Bezugszeichen bezeichnet sind, denen jedoch zur Unterscheidung der beiden Kondensatoren 12 und 12c der Kleinbuchstabe c nachgestellt ist.

Der Kondensator 12c enthält insbesondere die folgenden Bestandteile, für die die oben getroffenen Aussagen bzgl. der entsprechenden Teile des Kondensators 12 gelten:
- ein Substrat 14c,
- eine Wanne 20c,
- Anschlussbereiche 22c, 24c,
- einen Gatebereich 30c,
- einen Silizidbereich 32c,
- Abstandselemente 34c, 36c,
- Isoliergräben 40c, 42c,
- Substratanschlussbereiche 44c, 46c,
- Zwischenbereiche 48c, 50c, und
- Silizidbereiche 60c bis 66c.

Der Kondensators 12c hat im Vergleich zum Kondensator 12 die folgenden Abweichungen:
- eine Betriebspotenzialleitung 200 führt zu den Silizidbereichen 62c und 64c,
- eine Betriebspotenzialleitung 202 führt zu den Silizidbereichen 32c wobei die Betriebspotenzialleitungen 200 und 202 voneinander verschiedene Potenziale führen. Die Silizidbereiche 60c und 66c liegen bei beiden Polungsarten auf Massepotential. So kommen beide Polungsarten zum Einsatz, d.h. insbesondere auch eine Polung, bei der das Potenzial der Betriebspotenzialleitung 202 größer als das Potenzial der Betriebspotenzialleitung 200 ist.
- im Kondensator 12c sind n-dotierte LDD-Bereiche 204 und 206 bzw. Erweiterungsbereiche dargestellt, die unterhalb der Abstandselemente 34c und 36c liegen. Die Dotierstoffkonzentration der LDD-Bereiche 204, 206 liegt bspw. im Bereich von 5 10¹⁸ bis 1 10²⁰ Dotierstoffatome je Kubikzentimeter und
- ein dem Hilfsdotierbereich 26b entsprechender Hilfsdotierbereich fehlt im Kondensator 12c. Bei einem alternativen Ausführungsbeispiel ist jedoch ein solcher Hilfsdotierbereich vorhanden.
- an Stelle des Dielektrikums 28b mit gleichmäßiger Dicke ist im Kondensator eine Dielektrikum mit einem dünnen zentralen Dielektrikumsbereich 208 und einem dicken Rand-Dielektrikumsbereichen 210 vorhanden.

Die Dicke des zentralen Dielektrikumbereiches 208 stimmt mit der Dicke des dünnsten in der Schaltungsanordnung 10c vorhanden Dielektrikums überein. Bspw. beträgt die Dicke des zentralen Dielektrikumbereiches 208 2 Nanometer. Der dünne Dielektrikumsbereich 208 gewährleistet eine hohe flächenbezogene Kapazität des Kondensators 12c.

Die Dicke des Rand-Dielektrikumbereiches 210 stimmt mit der Dicke eines weiteren Dielektrikums in der Schaltungsanordnung 10c überein und beträgt bspw. 5 Nanometer. Der dicke Rand-Dielektrikumbereich 210 gewährleistet eine hohe ESD-Festigkeit des Kondensators 12c.

Bei anderen Ausführungsbeispielen werden die an Hand der Figuren 1 und 3 oder die an Hand der Figuren 2 und 3 erläuterten Maßnahmen kombiniert, um die ESD-Festigkeit weiter zu erhöhen.

Bei anderen Ausführungsbeispielen werden an Stelle der an Hand der Figuren 1 bis 3 erläuterten NCAP bei Wahl des jeweils anderen Dotiertyps in den Bereichen und bei umgekehrter Polung des Kondensators PCAPs hergestellt. Bei weiteren Ausführungsbeispielen werden bei sonst gleichen Dotierungen Anschlussbereiche des anderen Dotiertyps verwendet.

Bei weiteren Ausführungsbeispielen wird an Stelle einer dotierten Wanne ein dotierter Bereich auf einem Isolierbereich verwendet, wie es bei der SOI-Technik (Silicon On Insulator) der Fall ist.

### Bezugszeichenliste

10, 10b, 10c Schaltungsanordnung
12, 12b, 12c Kondensator
14, 14b, 14c Substrat
16, 16b Plusleitung
18, 18b Masseleitung
20, 20b, 20c Wanne
B Breite
22, 22b, 22c Anschlussbereich
24, 24b, 24c Anschlussbereich
26, 26b Hilfsdotierbereich
28, 28b, 28c Dielektrikum
30, 30b, 30c Gatebereich
32, 32b, 32c Silizidbereich
34, 34b, 34c Abstandselement
36, 36b, 36c Abstandselement
40, 40b, 40c Isoliergraben
42, 42b, 42c Isoliergraben
44, 44b, 44c Substratanschlussbereich
46, 46b, 46c Substratanschlussbereich
48, 48b, 48c Zwischenbereich
50, 50b, 50c Zwischenbereich
52, 54 Isoliergraben
60 bis 66 Silizidbereich
60b bis 66b Silizidbereich
60c bis 66c Silizidbereich
70 Verarmungsschicht
D Schichtdicke
80 Koordinatensystem
82 Potenzialverlauf
84 x-Achse
86 y-Achse
A Potenzialanstieg
90 Koordinatensystem
92 Potenzialverlauf
94 x-Achse
96 y-Achse
100, 102 Ladung
104 Sperrschichtkondensator
110, 112 Kante
140, 150 Maske
152 Maskenstruktur
160 bis 180 Maske
200, 202 Betriebspotenzialleitung
204, 206 LDD-Bereich
208 dünner Dielektrikumsbereich
210 dicker Dielektrikumsbereich

## Patentansprüche

1. Integrierte Schaltungsanordnung (10c),
mit zwei Betriebspotenzialleitungen (200, 202), die im Betrieb der Schaltungsanordnung (10c) voneinander verschiedene Potenziale führen,
und mit einem zwischen den Betriebspotenzialleitungen (200, 202) geschalteten Kondensator (12c), der die folgenden Bereiche enthält:
einen Grunddotierbereich (20c), der gemäß einem Grunddotiertyp dotiert ist,
mindestens einen dotierten Anschlussbereich (22c), dessen maximale Dotierstoffkonzentration höher als die maximale Dotierstoffkonzentration im Grunddotierbereich (20c) ist,
einem mit Abstand zum Grunddotierbereich angeordneten Elektrodenbereich (30c),
und mit einem zwischen dem Elektrodenbereich (30c) und dem Grunddotierbereich (20c) angeordneten Dielektrikum (208, 210),
wobei das Dielektrikum (208, 210) in einem dem Anschlussbereich (22) nahen Bereich (210) mindestens doppelt so dick ist, wie in einem mittleren Bereich (208) des Dielektrikums (208, 210), und
wobei an dem mindestens einen Anschlussbereich (22c, 24c) mindestens ein von dem Dielektrikum (210) zurückgesetzter Silizidbereich (62c, 64c) angeordnet ist.

2. Schaltungsanordnung nach Anspruch 1, **gekennzeichnet durch** mindestens ein Abstandselement (34c, 36c), das seitlich des Elektrodenbereiches (30c) angeordnet ist,
wobei der dickere Bereich (210) des Dielektrikums (208, 210) an das Abstandelement (34c, 36c) angrenzt.

3. Schaltungsanordnung nach Anspruch 1 oder 2, **dadurch gekennzeichnet, dass** der Anschlussbereich (22c, 24c) gemäß dem Grunddotiertyp dotiert ist,
oder dass der Anschlussbereich (22c, 24c) gemäß einem anderen Dotiertyp als der Grunddotiertyp dotiert ist.

4. Schaltungsanordnung nach einem der Ansprüche 1 bis 3, **dadurch gekennzeichnet, dass** das dicke Dielektrikum (210) dünner als 100 Nanometer oder dünner als 20 Nanometer ist, und dass die Schaltungsanordnung (10c) vorzugsweise mindestens einen Feldeffekttransistor, dessen Dielektrikum die Dicke des dünnen Dielektrikums (208) hat, und mindestens einen Feldeffekttransistor enthält, dessen Dielektrikum die Dicke des dicken Dielektrikums (210) hat.

5. Schaltungsanordnung nach einem der vorhergehenden Ansprüche, **dadurch gekennzeichnet, dass** zwischen den Silizidbereichen (62c, 64c) ein Siliziumbereich (20c) liegt, der nicht mit einem Silizidbereich (62c, 64c) bedeckt ist.

6. Schaltungsanordnung nach einem der vorhergehenden Ansprüche, **dadurch gekennzeichnet, dass** mindestens eines der folgenden Merkmale gilt:
die Betriebspotenzialleitungen (200, 202) führen zu Anschlüssen, über die beim Betrieb der Schaltungsanordnung (10c) eine äußere Betriebsspannung angelegt wird,
der Grunddotierbereich (20c) ist als Wanne ausgebildet, die vorzugsweise in einem Substrat (14c) angeordnet ist, das gemäß einem anderen Dotiertyp dotiert ist als der Grunddotierbereich (20c), und
der Kondensator (12c) ist als planares Bauelement ausgeführt, das in einer Ebene angeordnet ist, die parallel zu mindestens einer Metallisierungslage der integrierten Schaltungsanordnung (10c) angeordnet ist.

7. Verfahren zum Herstellen einer Schaltungsanordnung (10c) nach einem der Ansprüche 1 bis 6, mit den Schritten:
Ausbilden eines Grunddotierbereiches (20c) eines Kondensators (12c), der gemäß einem Grunddotiertyp dotiert wird,
Ausbilden eines Anschlussbereiches (22c) des Kondensators (12c),
Ausbilden eines dünnen Dielektrikums (208) des Kondensators (12c) in einem zentralen Bereich des Dielektrikums (208) des Kondensators (12c),
Ausbilden eines im Vergleich zu dem dünnen Dielektrikum (208) des Kondensators (12c) mindestens doppelt so dicken Dielektrikums (210) in einem Randbereich des Dielektrikums des Kondensators (12c),
Ausbilden eines vom Grunddotierbereich (20c) beabstandeten Elektrodenbereiches (30c) des Kondensators (12c), und
Ausbilden eines von dem Dielektrikum (210) zurückgesetzten Silizidbereichs (62c) am Anschlussbereich (22c).

8. Verfahren nach Anspruch 7, **gekennzeichnet durch** die Schritte:
Ausbilden zweier Betriebspotenzialleitungen (200, 202), die im Betrieb der Schaltungsanordnung (10c) voneinander verschiedene Potenziale führen, wobei die eine Betriebspotenzialleitung (200) mit dem Anschlussbereich (22) und die andere Betriebspotenzialleitung (202) mit dem Elektrodenbereich (30c) elektrisch leitfähig verbunden wird.

9. Verfahren nach Anspruch 7 oder 8, **dadurch gekennzeichnet, dass** das Dielektrikum (208, 210) vor dem Ausbilden eines Abstandselementes (34c, 36c) an dem Elektrodenbereich (30c) des Kondensators (12c) hergestellt wird.

10. Verfahren nach einem der Ansprüche 7 bis 9, **dadurch gekennzeichnet, dass** das dünne Dielektrikum (208) gleichzeitig mit einer dem Grunddotierbereich (20c) nahen Schicht des dicken Dielektrikums (210) oder vor dem Ausbilden des dicken Dielektrikums (210) ausgebildet wird,
oder dass das dünne Dielektrikum (208) nach dem Ausbilden einer dem Grunddotierbereich (20c) nahen Schicht des dicken Dielektrikums (210) ausgebildet wird.

## Claims

1. Integrated circuit arrangement (10c), comprising two operating potential lines (200, 202), which carry potentials that are different from one another during operation of the circuit arrangement (10c),
and comprising a capacitor (12c) connected between the operating potential lines (200, 202), said capacitor containing the following regions:
a basic doping region (20c) doped in accordance with a basic doping type,
at least one doped connection region (22c), the maximum dopant concentration of which is higher than the maximum dopant concentration in the basic doping region (20c),
an electrode region (30c) arranged at a distance from the basic doping region,
and comprising a dielectric (208, 210) arranged between the electrode region (30c) and the basic doping region (20c),
the dielectric (208, 210), in a region (210) near the connection region (22), being at least twice as thick as in a central region (208) of the dielectric (208, 210), and
at least one silicide region (62c, 64c), which is set back from the dielectric (210), being arranged at the at least one connection region (22c, 24c).

2. Circuit arrangement according to Claim 1, **characterized by** at least one spacer element (34c, 36c) arranged laterally with respect to the electrode region (30c),
the thicker region (210) of the dielectric (208, 210) adjoining the spacer element (34c, 36c).

3. Circuit arrangement according to Claim 1 or 2, **characterized in that** the connection region (22c, 24c) is doped in accordance with the basic doping type,
or **in that** the connection region (22c, 24c) is doped in accordance with a different doping type than the basic doping type.

4. Circuit arrangement according to one of Claims 1 to 3, **characterized in that** the thick dielectric (210) is thinner than 100 nanometers or thinner than 20 nanometers, and **in that** the circuit arrangement (10c) preferably has at least one field effect transistor whose dielectric has the thickness of the thin dielectric (208), and contains at least one field effect transistor whose dielectric has the thickness of the thick dielectric (210).

5. Circuit arrangement according to one of the preceding claims, **characterized in that** a silicon region (20c) not covered with a silicide region (62c, 64c) lies between the silicide regions (62c, 64c).

6. Circuit arrangement according to one of the preceding claims, **characterized in that** at least one of the following features holds true:
the operating potential lines (200, 202) lead to connections via which an external operating voltage is applied during operation of the circuit arrangement (10c),
the basic doping region (20c) is formed as a well that is preferably arranged in a substrate (14c) doped in accordance with a different doping type than the basic doping region (20c), and
the capacitor (12c) is embodied as a planar component arranged in a plane arranged parallel to at least one metallization layer of the integrated circuit arrangement (10c).

7. Method for the production of a circuit arrangement (10c) according to one of Claims 1 to 6, comprising the steps of:
forming a basic doping region (20c) of a capacitor (12c), doped in accordance with a basic doping type,
forming a connection region (22c) of the capacitor (12c),
forming a thin dielectric (208) of the capacitor (12c) in a central region of the dielectric (208) of the capacitor (12c),
forming a dielectric (210) that is at least twice as thick in comparison with the thin dielectric (208) of the capacitor (12c) in an edge region of the dielectric of the capacitor (12c),
forming an electrode region (30c) of the capacitor (12c), said electrode region being spaced apart from the basic doping region (20c), and
forming a silicide region (62c), which is set back from the dielectric (210), at the connection region (22c).

8. Method according to Claim 7, **characterized by** the steps of:
forming two operating potential lines (200, 202), which carry potentials that are different from one another during operation of the circuit arrangement (10c), one operating potential line (200) being electrically conductively connected to the connection region (22) and the other operating potential line (202) being electrically conductively connected to the electrode region (30c).

9. Method according to Claim 7 or 8, **characterized in that** the dielectric (208, 210) is produced prior to forming a spacer element (34c, 36c) at the electrode region (30c) of the capacitor (12c).

10. Method according to one of Claims 7 to 9, **characterized in that** the thin dielectric (208) is formed simultaneously with a layer of the thick dielectric (210) that is near the basic doping region (20c) or prior to forming the thick dielectric (210),
or **in that** the thin dielectric (208) is formed after forming a layer of the thick dielectric (210) that is near the basic doping region (20c).

## Revendications

1. Circuit (10c) intégré,
comprenant deux lignes (200, 202) de potentiel de fonctionnement, qui, en fonctionnement du circuit (10c), conduisent des potentiels distincts l'un de l'autre,
et comprenant un condensateur (12c), qui est monté entre les lignes (200, 202) de potentiel de fonctionnement et qui a les parties suivantes :
une partie (20c) de dopage de base, qui est dopée suivant un type de dopage de base,
au moins une partie (22c) de borne dopée dont la concentration maximum de substance de dopage est plus grande que la concentration maximum de substance de dopage dans la partie (20c) de dopage de base,
une partie (30c) d'électrode disposée à distance de la partie de dopage de base,
et un diélectrique (208, 210) disposé entre la partie (30c) d'électrode et la partie (20c) de dopage de base,
dans lequel le diélectrique (208, 210) est, dans une partie (210) proche de la partie (22) de borne, au moins deux fois plus épais que dans une partie (208) médiane du diélectrique (208, 210), et
dans lequel, sur la au moins une partie (22c, 24c) de borne, est disposée au moins une partie (62c, 64c) de siliciure en retrait du diélectrique (210).

2. Circuit suivant la revendication 1, **caractérisé par** au moins un élément (34c, 36c) d'intercalation, qui est disposé latéralement à la partie (30c) d'électrode,
la partie (210) plus épaisse du diélectrique (208, 210) étant voisine de l'élément (34c, 36c) d'intercalation.

3. Circuit suivant la revendication 1 ou 2, **caractérisé en ce que** la partie (22c, 24c) de borne est dopée suivant le type de dopage de base,
ou **en ce que** la partie (22c, 24c) de borne est dopée suivant un autre type de dopage que le type de dopage de base.

4. Circuit suivant l'une des revendications 1 à 3, **caractérisé en ce que** le diélectrique (210) épais est plus mince que 100 nanomètres ou plus mince que 20 nanomètres et **en ce que** le circuit (10c) a de préférence au moins un transistor à effet de champ, dont le diélectrique a l'épaisseur du diélectrique (208) mince et comporte au moins un transistor à effet de champ, dont le diélectrique a l'épaisseur du diélectrique (210) épais.

5. Circuit suivant l'une des revendications précédentes, **caractérisé en ce que** entre la partie (62c, 64c) de siliciure, se trouve une partie (20c) de silicium, qui n'est pas recouverte par une partie (62c, 64c) de siliciure.

6. Circuit suivant l'une des revendications précédentes, **caractérisé par** au moins l'une des caractéristiques suivantes :
les lignes (200, 202) de potentiel de fonctionnement mènent à des bornes par lesquelles, en fonctionnement du circuit (10c), est appliquée une tension de fonctionnement extérieure,
la partie (20c) de dopage de base est constituée en cuvette, qui est disposée de préférence dans un substrat (14c), lequel est dopé suivant un autre type de dopage que la partie (20c) de dopage de base, et
le condensateur (12c) est réalisé sous la forme d'un composant plan, qui est disposé dans un plan, lequel est parallèle à au moins une couche de métallisation du circuit (10c) intégré.

7. Procédé de production d'un circuit (10c) suivant l'une des revendications 1 à 6, comprenant les stades :
constitution d'une partie (20c) de dopage de base d'un condensateur (12c), qui est dopée suivant un type de dopage de base,
constitution d'une partie (22c) de borne du condensateur (12c),
constitution d'un diélectrique (208) mince du condensateur (12c) dans une partie centrale du diélectrique (208) du condensateur (12c),
constitution, dans une partie de bord du diélectrique du condensateur (12c), d'un diélectrique (210) au moins deux fois aussi épais que le diélectrique (208) mince du condensateur (12c),
constitution d'une partie (30c) d'électrode, à distance de la partie (20c) de dopage de base, du condensateur (12c) et
constitution d'une partie (62c) de siliciure, en retrait du diélectrique (210), sur la partie (22c) de borne.

8. Procédé suivant la revendication 7, **caractérisé par** les stades :
constitution de deux lignes (200, 202) de potentiel de fonctionnement, qui, en fonctionnement du circuit (10c), conduisent des potentiels distincts l'un de l'autre, dans lequel l'une des lignes (200) de potentiel de fonctionnement est reliée d'une manière conductrice de l'électricité à la partie (22) de borne et l'autre ligne (202) de potentiel de fonctionnement est reliée d'une manière conductrice de l'électricité à la partie (30c) d'électrode.

9. Procédé suivant la revendication 7 ou 8, **caractérisé en ce que** l'on produit le diélectrique (208, 210) avant la constitution d'un élément (34c, 36c) d'intercalation sur la partie (30c) d'électrode du condensateur (12c).

10. Procédé suivant l'une des revendications 7 à 9, **caractérisé en ce que** l'on constitue le diélectrique (208) mince en même temps qu'une couche, proche de la partie (20c) de dopage de base, du diélectrique (210) épais ou avant la constitution du diélectrique (210) épais,
ou **en ce que** l'on constitue le diélectrique (208) mince après la constitution d'une couche, proche de la partie (20c) de dopage de base, du diélectrique (210) épais.
